# FASCICULE DE BREVET EUROPEEN

(11) **EP 1 501 193 B1**
(45) Date de publication et mention de la délivrance du brevet: **21.09.2011**
(21) Numéro de dépôt: 04103172.5
(22) Date de dépôt: 05.07.2004
(51) Int. Cl.: H03K 17/955

(54) **Procédé de commande d'un dispositif de détection de présence d'un utilisateur pour véhicule automobile**
Verfahren zum Steuern einer Einrichtung zur Erfassung des Vorhandenseins eines Benutzers für ein Kraftfahrzeug
Method to control a device for detecting the presence of a user for a vehicle

(30) Priorité: 21.07.2003 FR 0308857
(43) Date de publication de la demande: 26.01.2005
(73) Titulaire: Valeo Sécurité Habitacle, 94046 Créteil Cedex (FR)
(72) Inventeur: Robin, Jean-Yves, c/o VALEO SECURITE, 94042, CRETEIL (FR)
(74) Mandataire: Jacquot, Ludovic R. G.

(56) Documents cités:
- DE-A- 4 218 658
- DE-A- 19 800 143
- US-A1- 2002 125 994
- US-A1- 2003 095 040

## Description

La présente invention est relative à un dispositif de détection de présence d'un utilisateur équipant les véhicules automobiles pour sécuriser leur accès.

Dans le domaine d'application du véhicule automobile plus particulièrement concerné par la présente invention, le dispositif de détection de présence fait généralement partie d'un système plus complexe, dit mains-libres, sécurisant l'accès à un véhicule automobile, dans lequel un utilisateur autorisé à accéder au véhicule est authentifié grâce à l'échange de signaux radiofréquences entre un équipement d'identification situé au niveau du véhicule, et un identifiant portatif conservé par l'utilisateur.

Cet échange consiste généralement en un signal d'interrogation émis par l'équipement d'identification, auquel l'identifiant va répondre avec un signal de réponse contenant des données d'identification. L'équipement d'identification pourra par la suite comparer ces données d'identification avec ses propres données, et autoriser ou non la décondamnation, voire l'ouverture automatique de l'ouvrant, en fonction du résultat de la comparaison. Dans certains systèmes mains-libres connus, le signal d'interrogation est émis en basse fréquence, typiquement à 125 KHz. Dans d'autres systèmes, ce signal d'interrogation est émis à une fréquence plus élevée, typiquement de l'ordre de 433 MHz. Dans les deux types de systèmes, le signal de réponse est généralement émis à une fréquence située également aux alentours de 433 MHz.

Pour des raisons tenant notamment à la pollution électromagnétique ainsi qu'à la consommation d'énergie que cela représenterait alors que le véhicule est à l'arrêt, il n'est pas possible d'envisager de laisser l'équipement d'identification émettre en permanence, ni même de façon cyclique, un signal d'interrogation à destination d'identifiants susceptibles de se trouver à proximité du véhicule automobile. C'est pourquoi l'échange de signaux électromagnétiques n'est généralement initié que suite à l'actionnement, par l'utilisateur, d'un moyen de commande situé au voisinage de l'ouvrant, par exemple au niveau de la poignée de l'ouvrant. Différents types de moyens de commande sont connus qui vont du bouton mécanique fonctionnant comme un interrupteur, aux capteurs de type tactile.

Toutefois, cette solution a comme inconvénient d'effectuer une détection trop tardive de l'approche de l'utilisateur, car le temps nécessaire pour que l'équipement d'identification authentifie l'identifiant de l'utilisateur et commande la décondamnation la serrure est généralement supérieur à la durée nécessaire pour que l'utilisateur termine la course d'actionnement de la poignée. En d'autres termes, la serrure n'est généralement pas encore décondamnée lorsque l'utilisateur a terminé la course d'actionnement de la poignée, et il est parfois nécessaire qu'il actionne plusieurs fois la poignée avant d'obtenir l'ouverture de l'ouvrant.

Pour résoudre ce problème, il est connu, notamment du document US2003/0095040, d'utiliser un dispositif de détection de présence, ou un capteur d'approche, qui détecte la présence de la main d'un utilisateur au voisinage de l'ouvrant, avant même que cette dernière n'ait effectivement saisi la poignée, et ce, de manière à déclencher au plus tôt la phase d'authentification.

Dans cette solution cependant, le problème de consommation, certes résolu au niveau de l'équipement d'identification, se voit déporté au niveau du dispositif de détection de présence. A l'heure actuelle, un dispositif de détection de présence surveille en permanence s'il y a détection d'un objet à proximité. Il est donc constamment alimenté en énergie.

Comme un véhicule automobile peut avoir ses quatre portes, voire son coffre, équipé chacun d'un tel dispositif de détection de présence, la consommation en énergie peut devenir très vite excessive, et risque de décharger prématurément la batterie du véhicule si ce dernier est immobilisé trop longtemps.

Une solution pourrait consister à couper l'alimentation, au bout d'un certain temps sans détection, d'un ou de plusieurs des dispositifs de détection pour ne laisser fonctionner qu'un seul dispositif, de préférence celui situé au niveau de l'ouvrant du conducteur, et réduire ainsi la consommation globale. Une telle dégradation du mode de fonctionnement n'est cependant pas acceptable pour l'utilisateur final.

Par ailleurs, dans le cas où seul un dispositif de détection de présence équipe le véhicule, il n'existe aucune solution autre à ce jour que de couper de temps en temps l'alimentation du dispositif, au risque de rater une détection, risque d'autant plus grand que les capteurs sont en général utilisés avec un sensibilité faible, pour détecter dans une zone très proche.

La présente invention pour but de proposer une solution permettant de réduire la consommation du dispositif de détection sans dégrader sa fonctionnalité.

Ce but est atteint selon l'invention qui propose un procédé de commande d'un dispositif de détection de présence d'un utilisateur équipant un véhicule automobile, tel que défini dans les revendications 1 à 5.

L'invention et ses avantages seront mieux compris au vu de la description suivante faite en référence aux figures annexées dans lesquelles :
- La figure 1 illustre schématiquement le principe de l'invention dans le cas non limitatif d'un dispositif de détection de présence situé sur la portière du conducteur ;
- La figure 2 est une coupe horizontale d'un ouvrant de véhicule muni de sa poignée et d'un dispositif de détection de présence commandé selon le procédé de l'invention ;
- les figures 3a, 3b et 3c sont des diagrammes temporels illustrant le principe de commande selon l'invention, respectivement dans le cas où aucun utilisateur n'approche le véhicule, dans le cas où un utilisateur s'approche du véhicule mais ne saisit pas la poignée, et enfin dans le cas où un utilisateur s'approche du véhicule pour ouvrir la portière.

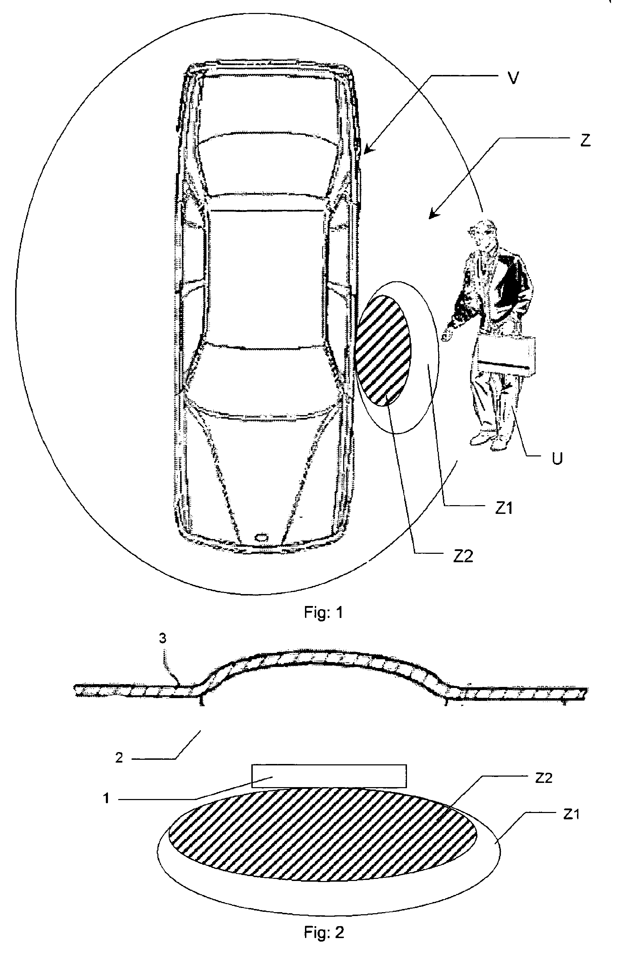

Sur la figure 1, on a représenté schématiquement un véhicule automobile V équipé d'un système d'accès mains-libres (non représenté) comprenant un équipement d'identification monté à bord du véhicule et un dispositif portatif, ou identifiant, porté par l'utilisateur, l'équipement embarqué et le dispositif portatif étant adaptés pour l'échange de signaux électromagnétiques dans une zone de dialogue Z prédéfinie. Plus précisément, l'identifiant génère, sur réception d'un signal d'interrogation émis par l'équipement, au moins un signal de réponse contenant un code d'identification, en vue d'être authentifié par l'équipement embarqué. Comme cela a été indiqué en introduction, on s'intéresse ici uniquement au cas où le dialogue précédant n'est initié que lorsque la présence d'un utilisateur U, potentiellement porteur d'un identifiant, a été détectée au préalable. Pour ce faire, le véhicule automobile comporte au moins un dispositif de détection de présence 1 (voir figure 2), disposé par exemple au niveau de la poignée 2 de la portière 3 du conducteur.

Conformément à l'invention, il est proposé de commander le dispositif de détection de présence 1 en agissant à la fois sur les durées pendant lesquelles le dispositif est alimenté, de manière à pouvoir effectuer des mesures, et sur la taille de la zone d'action du dispositif, c'est-à-dire de la zone surveillée par le dispositif 1.

Plus précisément, l'invention consiste :
- lors d'une première phase de surveillance, à alimenter le dispositif de détection de présence 1 de façon cyclique et permettre la surveillance par le dispositif dans une première zone Z1 dite lointaine ;
- en cas de détection d'un utilisateur dans ladite première zone Z1, à lancer une phase de surveillance dans laquelle le dispositif de détection de présence 1 est alimenté en continu et réalise une surveillance dans une seconde zone Z2 dite proche, incluse dans la première zone de surveillance Z1.

Le passage d'une zone de surveillance à l'autre s'effectue par simple modification de la sensibilité du dispositif de détection de présence. A titre d'exemple, la largeur de la zone Z1 (depuis la surface active du dispositif de détection vers l'extérieur) est de l'ordre de 4 cm, alors que la zone Z2 est de l'ordre du centimètre, voire inférieure.

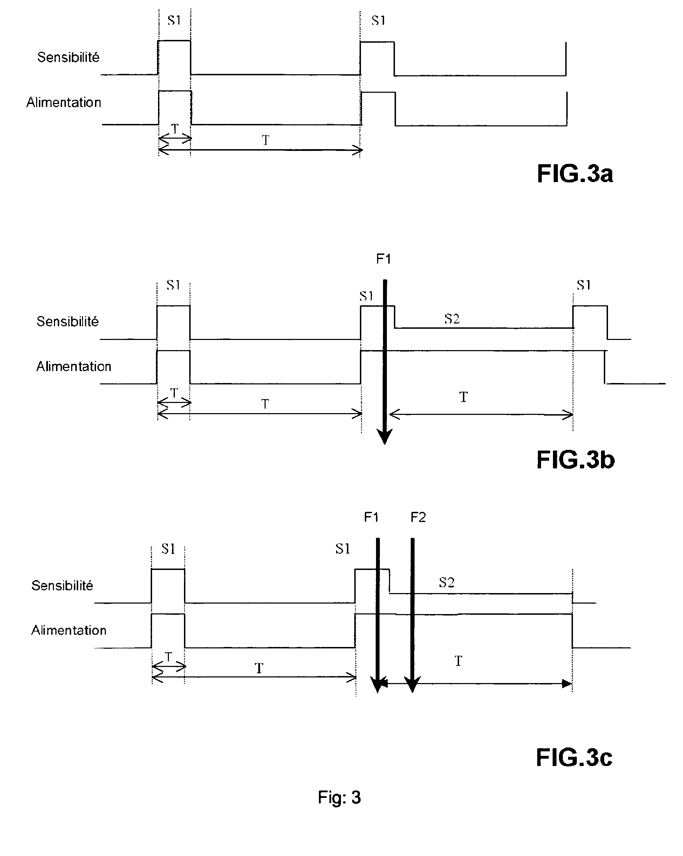

Différentes situations vont à présent être présentées en référence aux figures 3a à 3c. Sur l'ensemble de ces figures, on a représenté à chaque fois l'évolution temporelle de la sensibilité du dispositif de détection de présence, et l'évolution temporelle de son état alimenté ou non, conformément au procédé de commande selon l'invention :
La figure 3a illustre la commande d'un dispositif de détection de présence tel que celui de la figure 1, tant qu'aucun utilisateur U n'a été détecté. Ceci correspond à la première phase de surveillance précitée. Dans ce cas, la sensibilité S1 du dispositif de détection est réglée au maximum de manière à ce que la zone de surveillance corresponde à la zone Z1 (figures 1 et 2). En revanche, le dispositif 1 n'est alimenté que périodiquement (selon une période T2), sur une durée T1. Bien entendu, lorsque le détecteur n'est pas alimenté, sa sensibilité est nulle. Pour avoir un gain en consommation d'énergie, la durée T1 est de préférence inférieure ou égale à la moitié de la période T2. On obtient notamment des résultats très satisfaisants avec une durée T1 de l'ordre de 15% de la durée T2.
La figure 3b illustre le cas où une détection de présence est réalisée lors de la première phase de surveillance dans la zone dite lointaine Z1, bien qu'aucun utilisateur U ne saisisse effectivement la poignée par la suite. L'instant de détection est représenté par la flèche F1. Dans ce cas, conformément à l'invention, on passe dans une seconde phase de surveillance de durée T3, lors de laquelle le dispositif est alimenté en continu, mais sa sensibilité, et par suite la zone de surveillance, se voit réduite à la valeur S2 (correspondant à la zone de surveillance Z2). Ici, lors de cette seconde phase de surveillance, aucune autre détection de présence d'utilisateur n'est réalisée. Cela peut signifier soit, que la première détection était une fausse détection, soit que l'utilisateur, correctement détecté lors de la première phase, n'a finalement pas saisi la poignée de l'ouvrant. Dans tous les cas, au terme de la durée T3, qui peut être de l'ordre de grandeur de la durée T2, on revient à la première phase de surveillance. Bien entendu, comme aucune détection n'a été confirmée, le dialogue n'est pas initié entre l'équipement embarqué et un identifiant.
Dans la figure 3c, un utilisateur U s'approche du véhicule V dans le but réel de saisir la poignée. La présence de l'utilisateur est d'abord détectée à l'instant de détection représenté par la flèche F1, exactement comme expliqué en référence à la figure 3c. En revanche, comme l'utilisateur s'approche réellement de la poignée, le dispositif de détection de présence va pouvoir une seconde fois détecter la présence de l'utilisateur au cours de la seconde phase de surveillance à sensibilité réduite. L'instant de détection est ici représenté par la flèche F2. Cette seconde détection permet de confirmer la première, et le dialogue pour l'authentification peut dans ce cas être initié.

Une fois l'instant de détection F2 passé, on peut choisir d'arrêter l'alimentation du dispositif de détection. En variante, on peut considérer, comme représenté sur la figure 3c, que la durée T3 est fixe, et attendre que cette durée soit écoulée pour couper l'alimentation du dispositif de détection de présence.

Le procédé selon l'invention peut être mis en oeuvre quelle que soit la nature du dispositif de détection de présence, la seule nécessité étant que le dispositif puisse avoir sa sensibilité modifiée. On peut notamment utiliser des capteurs de type capacitif.

La sensibilité peut être modifiée par exemple de façon logicielle en modifiant une valeur de seuil au-delà de laquelle le capteur délivre un signal de détection.

On comprend que l'invention s'applique quel que soit l'endroit où est placé le capteur, et quel que soit l'ouvrant considéré.

On peut également considérer que la commande d'un dispositif de détection conforme à la présente invention peut être appliquée pour des fonctionnalités autres que l'ouverture d'ouvrants, en dehors de tout système d'accès mains-libres.

## Revendications

1. Procédé pour la commande d'un dispositif de détection de présence (1) d'un utilisateur (U) équipant un véhicule automobile (V), **caractérisé en ce qu** 'il comporte les phases suivantes :
- une première phase de surveillance en zone dite lointaine lors de laquelle le dispositif de détection de présence (1) est alimenté de façon cyclique pour détecter un utilisateur (U) présent dans une première zone prédéterminée (Z1);
- en cas de détection (F1) d'un utilisateur dans ladite première zone prédéterminée (Z1), une seconde phase de surveillance dans une zone dite proche lors de laquelle le dispositif de détection de présence est alimenté en continu pour détecter un utilisateur présent dans une seconde zone prédéterminée (Z2) incluse dans la première zone (Z1).

2. Procédé selon la revendication 1, **caractérisé en ce que**, lors de la première phase de surveillance, le dispositif de détection de présence (1) est alimenté périodiquement selon une période T2 prédéfinie, pendant une durée T1 inférieure ou égale à la moitié de ladite période T2.

3. Procédé selon la revendication 2, **caractérisé en ce que** la durée T1 est de l'ordre de 15% de la période T2.

4. Procédé selon l'une quelconque des revendications précédentes, **caractérisé en ce que** la première phase de surveillance est réitérée si aucune détection de présence n'a eu lieu lors de la seconde phase de surveillance.

5. Procédé selon l'une quelconque des revendications précédentes, **caractérisé en ce que** le dispositif de détection de présence (1) n'est plus alimenté dès lors qu'une détection a eu lieu durant la seconde phase de surveillance.

## Claims

1. Method for controlling a device (1) for detecting the presence of a user (U), the said device being fitted to a motor vehicle (V), **characterized in that** it comprises the following phases:
- a first phase of monitoring in a zone said to be a far zone during which the presence-detection device (1) is powered in a cyclical manner in order to detect a user (U) who is present in a first predetermined zone (Z1);
- in the event of detection (F1) of a user in the said first predetermined zone (Z1), a second phase of monitoring in a zone said to be a near zone during which the presence-detection device is powered continuously in order to detect a user who is present in a second predetermined zone (Z2) included in the first zone (Z1).

2. Method according to Claim 1, **characterized in that**, during the first monitoring phase, the presence-detection device (1) is powered periodically according to a predefined period T2, for a duration T1 that is less than or equal to half of the said period T2.

3. Method according to Claim 2, **characterized in that** the duration T1 is of the order of 15% of the period T2.

4. Method according to any one of the preceding claims, **characterized in that** the first monitoring phase is reiterated if no presence was detected during the second monitoring phase.

5. Method according to any one of the preceding claims, **characterized in that** the presence-detection device (1) is no longer powered if a detection took place during the second monitoring phase.

## Patentansprüche

1. Verfahren zur Steuerung einer Vorrichtung zur Erfassung der Anwesenheit (1) eines Benutzers (U), die zur Ausstattung eines Kraftfahrzeugs (V) gehört, **dadurch gekennzeichnet, dass** es die folgenden Phasen aufweist:
- eine erste Überwachungsphase in einer so genannten fernen Zone, während der die Anwesenheitserfassungsvorrichtung (1) zyklisch gespeist wird, um einen in einer ersten Vorbestimmten Zone (Z1) befindlichen Benutzer (U) zu erfassen;
- im Fall einer Erfassung (F1) eines Benutzers in der ersten Vorbestimmten Zone (Z1), eine zweite Überwachungsphase in einer so genannten nahen Zone, während der die Anwesenheitserfassungsvorrichtung kontinuierlich gespeist wird, um einen Benutzer zu erfassen, der sich in einer zweiten Vorbestimmten, in der ersten Zone (Z1) enthaltenen Zone (Z2) befindet.

2. Verfahren nach Anspruch 1, **dadurch gekennzeichnet, dass** in der ersten Überwachungsphase die Anwesenheitserfassungsvorrichtung (1) periodisch gemäß einer vorab definierten Periode T2 während einer Dauer T1 kürzer als die oder gleich der Hälfte der Periode T2 gespeist wird.

3. Verfahren nach Anspruch 2, **dadurch gekennzeichnet, dass** die Dauer T1 in der Größenordnung von 15% der Periode T2 liegt.

4. Verfahren nach einem der vorhergehenden Ansprüche, **dadurch gekennzeichnet, dass** die erste Überwachungsphase wiederholt wird, wenn keine Anwesenheitserfassung während der zweiten Überwachungsphase stattgefunden hat.

5. Verfahren nach einem der vorhergehenden Ansprüche, **dadurch gekennzeichnet, dass** die Anwesenheitserfassungsvorrichtung (1) nicht mehr gespeist wird, sobald eine Erfassung während der zweiten Überwachungsphase stattgefunden hat.
